(19) Europäisches Patentamt
European Patent Office
Office européen des brevets

(11) Veröffentlichungsnummer: **0 133 266**
**B1**

# (12) EUROPÄISCHE PATENTSCHRIFT

(45) Veröffentlichungstag der Patentschrift: **01.04.87**

(51) Int. Cl.⁴: **G 03 C 1/68**, G 03 F 7/10

(21) Anmeldenummer: **84108681.2**

(22) Anmeldetag: **23.07.84**

(54) **Verfahren zur Herstellung von Reliefformen mit speziellen ungesättigten Amiden.**

(30) Priorität: **30.07.83 DE 3327521**

(43) Veröffentlichungstag der Anmeldung: **20.02.85 Patentblatt 85/8**

(45) Bekanntmachung des Hinweises auf die Patenterteilung: **01.04.87 Patentblatt 87/14**

(84) Benannte Vertragsstaaten: **BE DE FR GB**

(56) Entgegenhaltungen:
**DE - A - 1 447 932**
**FR - A - 2 057 914**

(73) Patentinhaber: **BASF Aktiengesellschaft, Carl-Bosch-Strasse 38, D-6700 Ludwigshafen (DE)**

(72) Erfinder: **Bronstert, Bernd, Dr., Zanderstrasse 35, D-6701 Otterstadt (DE)**
Erfinder: **Gath, Rudolph Hans, Dr., Eilenburger Weg 41, D-6800 Mannheim 31 (DE)**
Erfinder: **Petersen, Harro, Dr., Kalmitstrasse 23, D-6710 Frankenthal (DE)**

**EP 0 133 266 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

**Beschreibung**

Die Erfindung betrifft ein Verfahren zur Herstellung von Reliefformen, insbesondere Druckformen, durch bildmässiges Belichten einer Schicht aus einer photovernetzbaren Mischung, die einen Photoinitiator und Verbindungen mit wiederkehrenden Amidgruppen und (Meth)acryl-Gruppen, ggf. in Mischung mit anderen photopolymerisierbaren olefinisch ungesättigten Verbindungen und/oder polymeren Bindemitteln enthält, und anschliessendes Entfernen, insbesondere Auswaschen der unbelichteten Schichtanteile.

Es ist bekannt, Reliefformen unter Verwendung von photopolymerisierbaren Mischungen mit Verbindungen mit wiederkehrenden Amidgruppen herzustellen. So bestehen handelsübliche Photopolymerdruckplatten aus durch aktinische Belichtung unlöslich werdenden Mischungen von alkohollöslichen Polyamiden, insbesondere Copolyamiden mit photopolymerisierbaren Monomeren und Photoinitiatoren. Sie zeichnen sich durch ihre hohe Abriebfestigkeit aus, womit die Herstellung hoher Auflagen mit diesen Druckformen möglich ist. Eine bekannte Schwierigkeit ist jedoch die Auswahl geeigneter Monomerer, die mit den Polyamiden zu lagerfähigen, verträglichen Schichten kombiniert werden können. Weniger polare Monomere neigen zum Ausschwitzen und polare Monomere bei Anwendung in grösserer Menge zur Auskristallisation und zum Entstehen von Trübungen. Es hat nicht an Versuchen gefehlt, geeignete Mischungen für diesen Zweck zu finden (vgl. z.B. DE-A-1522463, 1522469, 1522270, 2064742 und 2238567).

Aus der 1960 veröffentlichten GB-A-854980 ist auch bekannt, ungesättigte polymere Polyamid-Bindemittel und Mischungen davon mit Monomeren dadurch herzustellen, dass höhermolekulare Polyamide zuerst mit Formaldehyd und Alkohol z.B. zu N-Methoxymethyl-polyhexamethylenadipamid umgesetzt werden und diese dann durch Reaktion mit Methacrylsäure in N-Methacrylyloxymethylpolyamide mit $CH_2{=}CCH_3\text{-}CO\text{-}O\text{-}CH_2\text{-}N{<}$-Gruppen überführt werden. Aufgrund der bekannten Schwierigkeiten bei der Umsetzung von hochpolymeren Polyamiden und der leicht eintretenden Vernetzung bei der Umsetzung ist jedoch die reproduzierbare Herstellung von Umsetzungsprodukten mit gleichbleibenden Eigenschaften schwierig, so dass die beschriebenen Umsetzungsprodukte bis heute keine kommerzielle Anwendung fanden.

Der vorliegenden Erfindung lag die Aufgabe zugrunden, leicht zugängliche ungesättigte Verbindungen mit mehreren Amidgruppen zu finden, die als vorteilhafte Photovernetzer bei der Herstellung von Reliefformen und insbesondere Druckformen geeignet sind und bei Anwendung kurzer Belichtungszeiten zu Druckformen hoher Härte bei gutem Druckvermögen und hoher Auflagenfestigkeit führen. Eine weitere Aufgabe war es, Photovernetzer zu finden, die verbesserte Verträglichkeiten mit Polyamid- und insbesondere alkohollöslichen Copolyamid-Bindemitteln zeigen bzw. die Verträglichkeit von photopolymerisierbaren Monomeren mit diesen Bindemitteln verbessern.

Es wurde nun gefunden, dass ein Verfahren zur Herstellung von Reliefformen, insbesondere Druckformen, durch bildmässiges Belichten einer Schicht aus einer Mischung, die einen Photoinitiator und Verbindungen mit wiederkehrenden Amidgruppen sowie Acryl- und/oder Methacrylgruppen enthält, und anschliessendes Entfernen, insbesondere Auswaschen, der unbelichteten Schichtanteile, dann die gewünschten Vorteile zeigt, wenn die Verbindungen mit wiederkehrenden Amidgruppen sowie Acryl- und/oder Methacrylgruppen alkohollösliche Umsetzungsprodukte von ggf. ethoxylierten Oligolactamen (mit weniger als 10 Lactam-Bausteinen) mit N-Methylolacrylamid und/oder -methacrylamid darstellen.

Die erfindungsgemäss für die Herstellung von Reliefformen verwendeten Verbindungen mit Acryl- und/oder Methacrylgruppen sind Umsetzungsprodukte von (A) Oligolactamen oder ethoxylierten Oligolactamen mit weniger als 10 Lactam-Bausteinen im Molekül mit (B) N-Methylolacrylamid und/oder N-Methylolmethacrylamid.

N-Methylolacrylamid und N-Methylolmethacrylamid sind bekannte kristalline Verbindungen, die durch Umsetzung von Acrylamid oder Methacrylamid mit Formaldehyd bzw. Paraformaldehyd in Gegenwart von Dimethylethanolamin in Toluol hergestellt werden können.

Für die Umsetzung mit N-Methylol(meth)acrylamid geeignete Oligolactame können vorteilhaft durch Extraktion von im Polymerisationsgleichgewicht stehendem Polylactam wie Polycaprolactam mit heissem Wasser und Abtrennen des Monolactams wie des Caprolactams gewonnen werden (s. H. Zahn, J. Kunde und G. Heidemann, Makromolekulare Chemie 43 [1961] 220; Houben-Weyl, Methoden der organischen Chemie, 4. Aufl. Band XIV, Stuttgart 1963, Seiten 107, 113). Die so durch Heisswasserextraktion des Polylactams gewonnenen Oligomeren werden üblicherweise bis jetzt vernichtet. Die Herstellung der Oligolactame ist jedoch auch durch Oligomerisierung von z.B. ε-Caprolactam mit hoher Konzentration an Katalysator wie Propionsäure oder ε-Aminocapronsäure bei 280°C möglich, wobei die Oligomeren dann mit heissem Wasser extrahiert werden. Beim Abkühlen der wässrigen Lösung fallen die Oligomeren aus und können abgetrennt und im Vakuum getrocknet werden.

Ethoxylierte Oligolactame lassen sich durch Umsetzen von Oligolactamen mit mehr als 1 Mol Ethylenoxid pro Lactambaustein im Oligolactam im Druckreaktor bei Temperaturen von bevorzugt 120 bis 150°C während mehrerer Stunden in Gegenwart von Katalysator z.B. Natriummethylat herstellen. Je nach reagierter Ethylenoxidmenge lagern sich mehrere, überwiegend 1 bis 2, Moleküle Ethylenoxid pro Amidgruppen im Oligolactammolekül an, wobei gut wasserlösliche Produkte entstehen, die bevorzugt einen Gehalt an $-CH_2\text{-}CH_2\text{-}O$-Gruppen von 5 bis 50 Gew.-% aufweisen.

Die Umsetzung der Oligolactame oder der ethoxylierten Oligolactame mit N-Methylol(meth)acrylamid kann je nach gewünschtem Umsetzungsgrad bzw. Gehalt des Endproduktes an Acryl- bzw. Methacrylgruppierungen erfolgen und wird bevorzugt in Gegenwart einer Säure wie Phthalsäure und bevorzugt in einem höhersiedenden organischen Lösungsmittel, wie Toluol oder Xylol, unter Auskreisen des Reaktionswassers durchgeführt, im allgemeinen bei Temperaturen von 110 bis 150°C. Nach Neutralisation mit z.B. Natriummethylat kann durch Abdampfen des Lösungsmittels und Aufnehmen in alkoholischem Lösungsmittel wie Methanol das Reaktionsprodukt isoliert werden. Die Reaktionen verlaufen dabei überwiegend z.B. nach folgenden Reaktionsschemen:

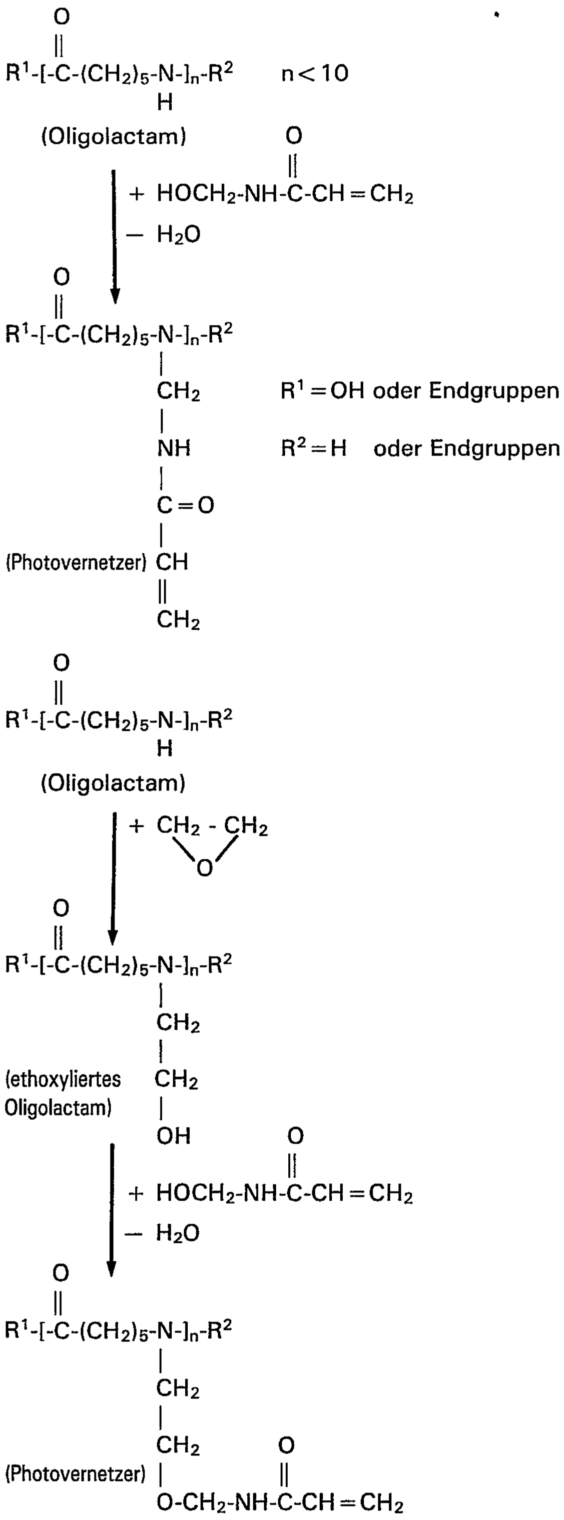


Die erfindungsgemäss verwendeten olefinisch ungesättigten Oligolactame lassen sich als Photovernetzer allein oder im Gemisch mit anderen Photovernetzern oder Bindemitteln für die Herstellung sehr harter Reliefformen verwenden. Von besonderem Vorteil ist aufgrund der Verträglichkeit ihre Verwendung zusammen mit Polyamiden als polymere Bindemittel und insbesondere alkohollöslichen Copolyamiden, wie sie in der FR-A-1 520 856 beschrieben sind. Auch mit Polyurethanen als polymere Bindemittel sind sie vorteilhaft für photovernetzbaren Mischungen, für Druckplatten und Reliefformen verwendbar. Es ist selbstverständlich möglich und für manche Verwendungen von Vorteil, die erfindungsgemäss verwendeten olefinisch ungesättigten Oligolactame im Gemisch mit anderen niedermolekularen olefinisch ungesättigten Verbindungen als Photovernetzer zu verwenden, wobei in vielen Fällen die erfindungsgemäss verwendeten ungesättigten Oligolactame als Verträglichkeitsvermittler zu Polyamid- oder Polyurethan-Bindemitteln dienen können. Von Monomeren, die im Gemisch mit den ungesättigten Oligolactamen verwendet werden können seien z.B. genannt die Monoacrylate und Monomethacrylate von Diolen und Polyolen, wie z.B. Ethylenglykol- oder Di-, Tri- oder Tetraethylenglykolmonoacrylat, Monomere mit zwei oder mehr olefinisch ungesättigten Bindungen, die Urethangruppen und/oder Amidgruppen enthalten, wie die aus aliphatischen Diolen der vorstehend genannten Art, organischen Diisocyanaten und Hydroxyalkyl(meth)acrylaten hergestellten niedermolekularen Verbindungen. Genannt seien auch Acrylsäure, Methacrylsäure sowie deren Derivate wie (Meth)acrylamid, N-Hydroxymethyl(meth)acrylamid, die Umsetzungsprodukte von 2 Mol N-Hydroxymethyl(meth)acrylamid mit 1 Mol eines aliphatischen Diols, wie Ethylenglykol, Xylylen-bisacrylamid oder Alkylen-bis-acrylamide mit 1 bis 8 C-Atomen im Alkylenrest.

Werden die erfindungsgemässen Photovernetzer allein oder im Gemisch mit anderen Monomeren als Photovernetzer in Kombinationen mit polymeren Bindemitteln verwendet, so beträgt im allgemeinen die Menge an Photovernetzern 10 bis 55 und insbesondere 35 bis 55 Gewichtsprozent, bezogen auf die Menge an Polymeren und photopolymerisierbaren Monomeren und wird u.a. von ihrer Verträglichkeit mit dem Polymeren und der gewünschten Härte der resultierenden Reliefform bestimmt.

Die photovernetzbaren Mischungen enthalten in bekannter Weise in Mengen von 0,01 bis 10 und insbesondere 0,01 bis 3 Gewichtsprozent, bezogen auf die Mischung, an Photoinitiatoren, als die praktisch alle Verbindungen geeignet sind, die bei Einwirkung von aktinischem Licht Radikale zu bilden vermögen, die eine Polymerisation auslösen. Als Photoinitiatoren kommen z.B. in Frage Acyloine und Acyloinether aromatische Diketone und deren Derivate, mehrkernige Chinone, Acridinderivate, Phenazinderivate.

Sehr geeignet sind Benzoin- und α-Hydroxymethylbenzoin sowie deren Alkylether mit 1 bis 8 C-Atomen wie Benzoinisopropylether, α-Hydroxymethyl-benzoinmethylether, Benzointetrahydropy-

ranylether oder Benzoinmethylether, Benzilmonoketale wie Benzilmonodimethylketal, Benzilmonomethylethylketal, Benzilmonomethylbenzylketal oder Benzilmononeopentylketal sowie Acylphosphinoxid-Verbindungen, wie sie in den DE-A-2909992 und 2909994 beschrieben sind.

Recht vorteilhaft hat sich auch erwiesen, der photovernetzbaren Mischung zusätzlich bekannte Polymerisationsinhibitoren zuzusetzen wie Nitrosamine, N-Nitrosohydroxylaminderivate, Phenole oder Phenolether, sofern dadurch die Mindestbelichtungszeit nicht wesentlich verlängert wird oder diese Verlängerung in Kauf genommen werden kann. Eine besonders positive Wirkung hat die Mitverwendung eines Salzes eines organischen N-Nitrosohydroxylamins wie den in der GB-A-1209232 beschriebenen N-Nitrosohydroxylaminsalzen der Formel

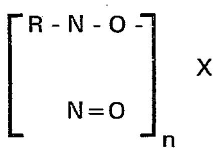

gezeigt, worin R einen organischen Rest und insbesondere einen Kohlenwasserstoffrest mit 1 bis zu 18 C-Atomen wie einen Alkylrest oder Cycloalkylrest (z.B. Methyl, Isopropyl, Butyl oder Cyclooctyl, Methylolcyclohexyl), Benzylrest, Phenylrest oder Naphthylrest und insbesondere Cyclohexyl, X gegebenenfalls substituiertes Ammonium oder insbesondere Metall, wie Magnesium, Cer, Aluminium und insbesondere Kalium oder Natrium darstellen und n eine Zahl ist, die der Wertigkeit von X entspricht. Hervorgehoben seien von den Verbindungen der vorstehenden Formel die Natrium-, Aluminium- und insbesondere Natrium- und Kaliumsalze des N-Nitroso-cyclohexyl-hydroxylamin. Die Verbindungen werden mit Vorteil in Mengen von 0,02 bis 2 und insbesondere 0,1 bis 0,8 Gewichtsprozent, bezogen auf die photovernetzbare Mischung, zugesetzt.

Die photovernetzbaren Mischungen können auch weitere übliche Zusätze enthalten wie Weichmacher, gesättigte niedermolekulare Verbindungen mit Amidgruppen und Wachse.

Die Verarbeitung der photovernetzbaren Mischung zu Platten, insbesondere Photopolymerdruckplatten, die schichtförmig die Mischung als reliefformende Schicht im allgemeinen in einer Schichtstärke von 200 bis 800 µm aufweisen, kann in bekannter Weise erfolgen und ist von der Art der Mischung und davon abhängig, ob die Mischung flüssig oder fest ist. Die Verarbeitung der Platten zu Reliefformen erfolgt in bekannter Art durch bildmässiges Belichten mit aktinischem Licht mit Lichtquellen, die Maxima der Emission im Bereich der Absorption der Photoinitiatoren, im allgemeinen im Bereich von 300 bis 400 nm besitzen oder einen ausreichenden Anteil von Licht dieses Wellenlängenbereiches aufweisen, wie Quecksilbermitteldruckstrahler, aber auch Hoch- und Niederdruckstrahler, oder superaktinische Leuchtstoffröhren. Nach der bildmässigen Belichtung werden die nichtbelichteten Anteile der Schicht in bekannter Art mechanisch entfernt oder bevorzugt mit Entwicklerlösungsmitteln ausgewaschen. Die resultierenden Reliefformen werden getrocknet und in manchen Fällen zweckmässigerweise noch voll nachbelichtet.

Die erfindungsgemäss verwendeten ungesättigten Oligolactame eignen sich besonders zur Herstellung von Reliefformen hoher Härte innerhalb relativ kurzen Belichtungszeiten. Überraschenderweise ergeben sie im Unterschied zu ähnlich strukturierten Monomeren mit üblichen Polyamid-Bindemitteln verträgliche Mischungen, die im unbelichteten Zustand auch bei hohen relativen Luftfeuchtigkeiten wochenlang gelagert und dennoch zur Herstellung qualitativ hochwertiger Reliefformen verwendet werden können.

Die in den folgenden Beispielen und Vergleichsversuchen genannten Teile und Prozente beziehen sich, soweit nicht anders angegeben, auf das Gewicht. Teile verhalten sich zu Volumenteilen wie Kilogramm zu Liter.

*Beispiel 1*

1a. Herstellung von Umsetzungsprodukt aus Oligolactam mit N-Methylolacrylamid

505 Teile N-Methylolacrylamid werden mit 565 Teilen Oligolactam (gewonnen aus im Polymerisationsgleichgewicht stehendem Polycaprolactam durch Extraktion mit heissem Wasser, Abkühlen auf Raumtemperatur und Trocknen im Vakuum bei 30°C) in 1500 Volumenteilen Xylol in Gegenwart von 25 Teilen Phthalsäure und 2 Teilen des Natriumsalzes des N-Nitrosocyclohexyl-hydroxylamins auf 122 bis 140°C erhitzt und unter Auskreisen von 65 Teilen Wasser umgesetzt. Nach Abkühlen auf 90°C erfolgt eine Zugabe von 25 Volumenteilen 30%igem methanolischem Natriummethylat. Dann wird im Vakuum das Lösungsmittel abgedampft und durch anschliessenden Zusatz von Methanol eine Lösung mit einem Feststoffgehalt von 25% eingestellt.

1b. Druckplatten- und Reliefherstellung

60 Teile eines alkohollöslichen Copolyamids, das durch Polykondensation von 35 Teilen Hexamethylendiammoniumadipat, 35 Teilen p,p'-Diammoniumcyclohexylmethan und 30 Teilen ε-Caprolactam hergestellt wurde, werden mit 30 Teilen des gemäss 1a hergestellten Umsetzungsproduktes von N-Methylolacrylamid mit Oligolactam, 2 Teilen Benzoinethylether als Photoinitiator, 0,02 Teilen 2,4,6-Trialkylphenol als Inhibitor der thermischen Polymerisation und 0,01 Teilen eines Chromkomplexfarbstoffes (C.I. Nr. 12195) in einem Methanol-Wasser-Gemisch (9:1 Vol.Teile) gelöst. Die Lösungen werden derart auf einem mit einem Haftlack versehenen Stahlblech zu Schichten vergossen, dass nach dem Trocknen eine Schichtdicke von 670 µm resultiert. Durch ein geeignetes Negativ wird die Druckplatte mit einem Flachbelichter mit einer UV-Lichtintensität von 3300 $\mu W/cm^2$ belichtet. Danach werden die unbelichteten Plattenanteile mit einem Ethanol-Wassergemisch 7 Minuten ausgewaschen und in einem handelsüblichen Trockner/Nachbelichter 6 Minuten bei 130°C behandelt.

Es wird die Kugeleindruckhärte H $cN/mm^2$ der resultierenden Reliefplatten nach mindestens 10tägiger offener Lagerung bei 60% relativer Feuchtigkeit unter Last bestimmt, ferner die Belichtungszeit (BZ), die für die Wiedergabe eines 3%igen Raster-Tonwerts bei 54 Linien pro cm erforderlich ist. Schliesslich wird die Verträglichkeit der unbelichteten photovernetzbaren Mischungen beurteilt, nachdem die Platten 4 Wochen bei Raumtemperatur und 80% relativer Feuchtigkeit gelagert wurden. Die Härte H beträgt 1060 $cN/mm^2$, die Belichtungszeit BZ 4 Minuten. Die Verträglichkeit der Mischungen nach Lagerung war gut.

*Beispiel 2*

Es wird wie in Beispiel 1 verfahren, jedoch werden 15 Teile des Umsetzungsproduktes von N-Methylolacrylamid mit Oligolactamen durch 15 Teile des Ethers von 1 Mol Ethylenglykol mit 2 Molen N-Methylolacrylamid ersetzt. Die Prüfung der resultierenden Reliefplatten entsprechend Beispiel 1 ergab eine Härte H von 750 $cN/mm^2$, eine Belichtungszeit von 4 Minuten. Die Verträglichkeit der Mischungen war nach der in Beispiel 1 angegebenen Lagerung gut.

*Beispiel 3*

3a. Herstellung von ethoxyliertem Oligolactam

500 Teile des in Beispiel 1a verwendeten trockenen Oligolactams werden in einem Druckreaktor mit 200 Teilen Ethylenoxid 3 Stunden bei einer Temperatur von 120 bis 150°C in Gegenwart von ca. 0,5% Natriummethylat bei einem Druck von 2 bis 6 bar umgesetzt. Die resultierenden wasserlöslichen ethoxylierten Oligolactame (Ethylenoxid-Aufnahme 160 Teile) werden in Wasser gelöst, dann isoliert und getrocknet.

3b. Herstellung von Umsetzungsprodukt aus ethoxyliertem Oligolactam und N-Methylolacrylamid

157 Teile gemäss 3a hergestelltes ethoxyliertes Oligolactam werden mit 101 Teilen N-Methylolacrylamid in Gegenwart von 5 Teilen Phthalsäure, 1 Teil einer 30%igen wässrigen Lösung des Natriumsalzes des N-Nitrosocyclohexyl-hydroxylamins in 400 Volumenteilen Xylol gelöst und erhitzt. Unter Rückfluss werden 18 Teile Wasser ausgekreist. Danach wird im Vakuum eingedampft, wobei 267 Teile Feststoff resultieren. Beim Lösen in 500 Teilen Methanol verbleiben 14 Teile an ungelöstem Anteil, der abgesaugt wird. Durch Zugabe von Methanol zur Lösung wird ein Feststoffgehalt der Lösung von 25% eingestellt.

3c. Druckplatten- und Reliefherstellung

Es wird wie in Beispiel 1b verfahren, jedoch werden anstelle von 30 Teilen des gemäss Beispiel 1a hergestellten Umsetzungsproduktes von N-Methylolacrylamid mit Oligolactam nur 15 Teile davon und 15 Teile eines gemäss 3a und 3b hergestellten Umsetzungsproduktes von N-Methylolacrylamid mit einem ethoxylierten Oligolactam (verwandt in Form der 25%igen methanolischen Lösung) für die Herstellung der photovernetzbaren Lösung für die Stahlplatten eingesetzt. Die resultierenden Reliefplatten haben eine Härte H von 750 $cN/mm^2$, eine Belichtungszeit BZ von 4 Minuten. Die Verträglichkeit der Mischungen nach der in Beispiel 1 angegebenen Lagerung war gut.

*Vergleichsversuch 1*

Es wird wie in Beispiel 1b verfahren, jedoch werden statt des Umsetzungsproduktes von N-Methylolacrylamid mit Oligolactam 30 Teile Triethylenglykoldiacrylat als Monomeres verwandt. Die resultierenden Reliefplatten weisen bei der in Beispiel 1b angegebenen Prüfung eine Härte H von 700 $cN/mm^2$ und eine Belichtungszeit BZ von 6 Minuten auf. Beim Lagern gemäss den Angaben in Beispiel 1b schwitzt das Monomere stark aus.

*Vergleichsversuch 2*

Es wird wie in Vergleichsversuch 1 verfahren, jedoch werden 30 Teile Methylenbisacrylamid als Monomeres verwendet. Die Härte H der resultierenden Reliefplatten beträgt 390 $cN/mm^2$, die Belichtungszeit 6 Minuten. Beim Lagern der unbelichteten Druckplatten während 4 Wochen bei 80% relativer Luftfeuchtigkeit kristallisiert das Monomere stark aus.

*Vergleichsversuch 3*

Es wird wie in Vergleichsversuch 1 verfahren, jedoch werden 30 Teile des Ethers aus 1 Mol Ethylenglykol und 2 Molen N-Methylolacrylamid als Monomeres verwendet. Die Härte H der Reliefplatten beträgt 700 $cN/mm^2$, die Belichtungszeit BZ 4 Minuten. Beim Lagern gemäss Beispiel 1b schwitzt das Monomere etwas aus.

*Vergleichsversuch 4*

Es wird wie in Vergleichsversuch 1 verfahren, jedoch werden 30 Teile des Diurethans aus 1 Mol Toluylendiisocyanat und 2 Mol 2-Hydroxyethylmethacrylat als Monomere verwendet. Die Härte H der resultierenden Reliefplatten beträgt 780 $cN/mm^2$, die Belichtungszeit BZ 10 Minuten. Die Verträglichkeit der unbelichteten Platten nach einer Lagerzeit von 4 Wochen bei 80% relativer Luftfeuchtigkeit ist gut.

*Vergleichsversuch 5*

Es wird wie in Vergleichsversuch 3 verfahren, der Mischung jedoch 12 Teile an N-(n-Butyl)-benzolsulfonamid als Verträglichkeitsvermittler zugesetzt. Die Härte H der resultierenden Reliefplatten beträgt nur 400 $cN/mm^2$, die Belichtungszeit BZ 4 Minuten. Die Verträglichkeit der unbelichteten Platten ist nach 4 Wochen Lagerung bei Raumtemperatur bei 80% relativer Luftfeuchtigkeit gut.

**Patentansprüche**

1. Verfahren zur Herstellung von Reliefformen, insbesondere Druckformen, durch bildmässiges Belichten einer Schicht aus einer photovernetzbaren Mischung, die einen Photoinitiator und Verbindungen mit wiederkehrenden Amidgruppen sowie (Meth)acrylgruppen enthält, und anschliessendes Entfernen, insbesondere Auswaschen, der unbelichteten Schichtanteile, dadurch gekennzeichnet, dass die Verbindungen mit wiederkehrenden Amidgruppen sowie Acryl- und/oder Methacrylgruppen alkohollösliche Umsetzungsprodukte von ggf. ethoxylierten Oligolactamen (mit weniger als 10 Lactam-Bausteinen) mit N-Methylolacrylamid und/oder -methacrylamid darstellen.

2. Verfahren nach Anspruch 1, dadurch gekennzeichnet, dass die Photoinitiator enthaltende Mischung zusätzlich als polymeres Bindemittel ein alkohollösliches Copolyamid enthält.

3. Verfahren nach einem der Ansprüche 1 oder 2, dadurch gekennzeichnet, dass die Photoinitiator enthaltende Mischung zusätzlich andere verträgliche photopolymerisierbare olefinisch ungesättigte Monomere enthält.

4. Verfahren nach einem der Ansprüche 1 bis 3, dadurch gekennzeichnet, dass die Verbindungen mit wiederkehrenden Amidgruppen sowie Acryl- und/oder Methacrylgruppen in Gegenwart von Säuren hergestellte Umsetzungsprodukte von ggf. ethoxylierten Oligolactamen (mit weniger als 10 Lactam-Bausteinen) mit N-Methylolacrylamid und/oder -methacrylamid darstellen.

5. Verfahren nach einem der Ansprüche 1 bis 4, dadurch gekennzeichnet, dass die Verbindungen mit wiederkehrenden Amidgruppen sowie Acryl- und/oder Methacrylgruppen Umsetzungsprodukte von ggf. ethoxyliertem, in heissem Wasser löslichen Oligocaprolactam mit N-Methylolacrylamid und/oder -methacrylamid darstellen.

6. Verfahren nach einem der Ansprüche 1 bis 5, dadurch gekennzeichnet, dass die Verbindungen mit wiederkehrenden Amidgruppen sowie Acryl- und/oder Methacrylgruppen Umsetzungsprodukte von ethoxylierten Oligolactamen (mit weniger als 10 Lactam-Bausteinen sowie einem Gehalt an $-CH_2-CH_2-O-$Gruppen von 5 bis 50 Gew.-%) mit N-Methylolacrylamid und/oder -methacrylamid darstellen.

7. Reliefform, hergestellt nach einem der Ansprüche 1 bis 6.

**Claims**

1. A process for the production of relief plates, especially printing plates, by imagewise exposure of a layer consisting of a photocrosslinkable mixture which contains a photoinitiator and compounds with recurring amide groups as well as (meth)acrylyl groups, and subsequent removal, particularly washout, of the unexposed areas, wherein the compounds with recurring amide groups as well as acrylyl and/or methacrylyl groups are alcohol-soluble reaction products of optionally ethoxylated oligolactams (containing less than 10 lactam building blocks) with N-methylolacrylamide and/or N-methylolmethacrylamide.

2. A process as claimed in claim 1, wherein the photoinitiator-containing mixture additionally contains an alcohol-soluble copolyamide as polymeric binder.

3. Process as claimed in claim 1 or 2, wherein the photoinitiator-containing mixture additionally contains other compatible, photopolymerizable, olefinically unsaturated monomers.

4. A process as claimed in any of claims 1 to 3, wherein the compounds with recurring amide groups as well as acrylyl and/or methacrylyl groups are reaction products of optionally ethoxylated oligolactams (containing less than 10 lactam building blocks) with N-methylolacrylamide and/or N-methylolmethacrylamide, which products have been prepared in the presence of acids.

5. A process as claimed in any of claims 1 to 4, wherein the compounds with recurring amide groups as well as acrylyl and/or methacrylyl groups are reaction products of optionally ethoxylated oligocaprolactam, which is soluble in hot water, with N-methylolacrylamide and/or N-methylolmethacrylamide.

6. A process as claimed in any of claims 1 to 5, wherein the compounds with recurring amide groups as well as acrylyl and/or methacrylyl groups are reaction products of ethoxylated oligolactams (containing less than 10 lactam building blocks, and 5 to 50% by weight of $-CH_2-CH_2-O-$ groups) with N-methylolacrylamide and/or N-methylolmethacrylamide.

7. A relief plate produced according to any of claims 1 to 6.

**Revendications**

1. Procédé de fabrication de formes en relief, plus particulièrement de clichés d'impression, par exposition en conformité d'image d'une couche en un mélange photo-réticulable qui contient un photo-amorceur et des composés comportant des radicaux amide récurrents comme aussi des radicaux (méth)-acryle et élimination subséquente, en particulier dépouillement ou lixiviation, des fractions de la couche inexposées, caractérisé en ce que les composés comportant des radicaux amide récurrents, comme aussi des radicaux acryle et/ou méthacryle, constituent des produits de réaction, solubles dans l'alcool, d'oligolactames éventuellement éthoxylées (possédant moins de 10 éléments lactame) et de N-méthylolacryl- et/ou -méthacrylamide.

2. Procédé suivant la revendication 1, caractérisé en ce que le mélange contenant le photo-amorceur contient complémentairement un copolyamide soluble dans l'alcool à titre de liant polymère.

3. Procédé suivant l'une des revendications 1 et 2, caractérisé en ce que le mélange contenant le photo-amorceur contient complémentairement d'autres monomères à insaturation oléfinique, photopolymérisables et compatibles.

4. Procédé suivant l'une des revendications 1 à 3, caractérisé en ce que les composés avec des radicaux amide récurrents, comme aussi des radicaux acryle et/ou méthacryle constituent des produits de réaction d'oligolactames éventuellement éthoxylées (possédant moins de 10 éléments lactame) et de N-méthylolacryl- et/ou -méthacrylamide, préparés en présence d'acides.

5. Procédé suivant l'une des revendications 1 à 4, caractérisé en ce que les composés avec des radicaux amide récurrents, comme aussi des radicaux acryle et/ou méthacryle constituent des produits de réaction de l'oligocaprolactame éventuellement éthoxylée, soluble dans l'eau chaude et du N-méthylol-acrylamide et/ou -méthacrylamide.

6. Procédé suivant l'une des revendications 1 à 5, caractérisé en ce que les composés comportant des radicaux amide récurrents, comme aussi des radicaux acryle et/ou méthacryle constituent des produits de réaction d'oligolactames éthoxylées (possédant moins de 10 éléments lactame ainsi qu'une teneur en radicaux $-CH_2-CH_2-O-$ de 5 à 50% en poids) et du N-méthylol-acrylamide et/ou -méthacrylamide.

7. Forme en relief fabriquée par mise en oeuvre du procédé suivant l'une des revendications 1 à 6.